Europäisches Patentamt

European Patent Office

Office européen des brevets

(19)

(11) Publication number: **0 249 088 B1**

## EUROPEAN PATENT SPECIFICATION

(12)

(45) Date of publication of patent specification: **17.03.93**

(51) Int. Cl.5: **H01L 27/06**, H01L 29/08, H01L 29/743

(21) Application number: **87107662.6**

(22) Date of filing: **26.05.87**

(54) **A semiconductor device.**

(30) Priority: **09.06.86 JP 134502/86**

(43) Date of publication of application:
**16.12.87 Bulletin 87/51**

(45) Publication of the grant of the patent:
**17.03.93 Bulletin 93/11**

(84) Designated Contracting States:
**DE FR GB**

(56) References cited:
US-A- 3 564 356
US-A- 3 812 405

IEEE TRANSACTIONS ON ELECTRON DE-
VICES, vol. ED-29, no. 2, February 1982,
pages 341-343, IEEE, New York, US; T.E. ZIP-
PERIAN et al.: "Channel-collector transis-
tors"

IEEE INTERNATIONAL SOLID-STATE CIR-
CUITS CONFERENCE, vol. 24, February 1981,
pages 40-41, New York, US; W.M. WERNER et
al.: "Gate underlaid transistor"

(73) Proprietor: **TEXAS INSTRUMENTS INCORPO-
RATED**
**13500 North Central Expressway**
**Dallas Texas 75265(US)**

(72) Inventor: **Kuwano, Hiromichi**
**6-12, Kita-Aoyama 3-chome Minato-ku**
**Tokyo(JP)**

(74) Representative: **Leiser, Gottfried, Dipl.-Ing. et
al**
**Patentanwälte Prinz, Leiser, Bunke & Partner**
**Manzingerweg 7**
**W-8000 München 60 (DE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

**Description**

BACKGROUND OF THE INVENTION

Field of the Invention

The present invention relates to an integrated circuit semiconductor structure as described in the precharacterizing part of claim 1.

Description of the Prior Art

Many bipolar IC semiconductor devices are fabricated in an epitaxial layer grown in a surface of semiconductor substrate. This epitaxial layer is reverse in conductivity type to the substrate, with a pn junction electrically isolating the epitaxial layer and substrate from each other. In the epitaxial layer, isolation walls of the same conductivity type as the substrate and/or isolation regions composed of an insulating substance are provided to form individual circuit element regions and wells electrically isolated from the surrounding thereof. Since each well is electrically isolated by a pn junction or the like at bottom (interface between the epitaxial layer and substrate) and at side walls, emitter, base and collector electrodes of bipolar junction transistor are all fabricated at top (the surface of epitaxial layer). With such electrode layout, as carriers flow from the emitter to the collector, these carriers necessarily move in a horizontal direction (parallel to the surface of epitaxial layer). If the well is formed as a region of high resistivity (with a low impurity concentration) providing a high resistivity in the horizontal direction, therefore, the collector series resistance, etc. becomes high. Such high collector series resistance results in an increase in the RC time constant, lowering the response speed of transistor. For this reason, many bipolar ICs are designed so that each well for fabrication of a transistor has an embedded region of high impurity concentration (subcollector region) in the surface of substrate or in proximity to the interface between the substrate and epitaxial layer, which is of the same conductivity type as the epitaxial layer and electrically continuous to such layer. The above subcollector region of high impurity concentration (low conductivity) spreads in the horizontal direction in the well, substantially reducing the resistivity of well in such direction and thereby allowing a faster response, etc. of transistor.

For the bipolar junction transistor with such embedded subcollector region, however, the emitter-collector withstand voltage is determined by the base-collector withstand voltage, namely, primarily by the impurity concentration and thickness (base-subcollector distance) of an epitaxial region sandwiched between the base region and subcollector region below the emitter region. The configuration (for example, the curvature) of the base region also affects the withstand voltage.

In a silicon region doped with impurities at a concentration of $10^{18}$ cm$^{-3}$ or under, the breakdown that occurs there is primarily of avalanche type. As the factor of causing the avalanche breakdown, a critical electrical field intensity, say, $10^5$ to $10^6$ V/cm is ordinarily assumed. As such critical electric field intensity is exceeded at some point in a transistor, there occurs a breakdown. Accordingly, to achieve a high withstand voltage, a large potential drop must be attained without exceeding the critical electric field intensity. For this end, it might seem to be effective to reduce the impurity concentration in the region of epitaxial layer between the base and subcollector regions and increase the thickness of such layer. However, thicker growth of the epitaxial layer of low impurity concentration has difficulties in the process control, etc. and tends to decrease the production yield. Further, since the epitaxial layer is ordinarily formed to a uniform thickness in the semiconductor wafer, the thickness of epitaxial layer increases also in other regions. Beside, it also becomes necessary to increase the depth and width of isolation walls. The above method will thus lead to a lower circuit integration by more complicated process. For this reason, the thickness of epitaxial layer is limited. As a result, bipolar transistors that have been fabricated for practical applications have withstand voltages up to about 60 V.

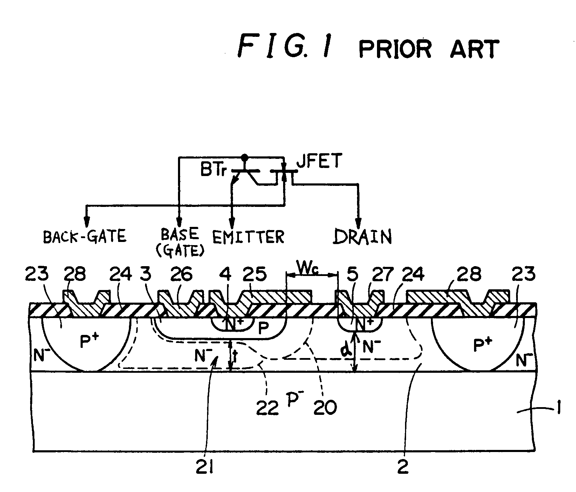

In view of the above circumstances, the authors already proposed a high withstand voltage semiconductor device that can solve the problems as mentioned above. The proposed semiconductor device with bipolar transistors as mentioned above fabricated thereon is characterized by such selection of the impurity concentration in the epitaxial layer (collector region) and the distance between the substrate and base region that as the collector voltage increases with a low level of singal voltage applied to the base region, the depletion layers extending from the semiconductor substrate and base region, respectively, grow in size large enough to cause the pinch-off condition before there appears any breakdown between collector and emitter regions. Fig. 1 is an example of such semiconductor device (in individual semiconductor regions, hatching of cross-sectional areas is omitted for easier understanding; the same applies to drawings hereinafter referred to). Referring to the switching npn bipolar transistor BTr of the above example, the embedded region of low resistivity as mentioned above is omitted with the n⁻ inner collector region 21 sandwiched between the p base region 3 and p⁻ substrate 1. The inner collector region 21 is set to such impurity concentration n⁻ and thickness t that, as a voltage higher than a given level Vc is applied to the collector 21, the depletion layers 20 and 22 extending from the base region 3 and substrate 1, respectively, come in contact as shown. Assuming that both the base region 3 and substrate 1 are grounded, the above requirement can be satisfied only if the width Wd of both depletion layers roughly conforms to the following inequality:

$$W_d \approx \sqrt{\frac{2 K_s \cdot \epsilon_0}{q \cdot n}} V_c \approx \sqrt{\frac{K_s \cdot V_c}{n}} \times 10^{14} \ (\mu m) > \frac{t}{2}$$

where $\epsilon_0$ is the dielectric constant of vacuum, Ks the relative dielectric constant, q the charge on the electron, and n the impurity concentration. In case of silicon (Ks $\approx$ 12), assuming n = $10^{15}$ cm$^{-3}$ and t = 6 $\mu$m, therefore, the voltage Vc required to bring the depletion layers in contact is about 8 V. With n = $10^{16}$ cm$^{-3}$ and the same t, the depletion layers come in contact at Vc $\approx$ 50 V.

The depletion layer is, in other words, a region where there is a potential gradient. As a continuous depletion layer is formed between the inner collector region 21 underlying the base region 3 and the collector's charge collection region 5 (this corresponds to the drain of JFET), therefore, the highest potential in the inner collector region 21 is naturally lower than the potential in the collector's charge collection region 5. Accordingly, the sum of the voltage of inner collector region 21 and the voltage drop from such inner collector region 21 to the collector's charge collection region 5 is the collector voltage of this compound transistor. Even when the voltage of the inner collector region 21 is limited to around the ordinary level, therefore, a high potential drop in the depletion layer gives a high collector voltage. This means that application of a high voltage to the collector, namely, region 5, will cause no avalanche breakdown below the emitter region.

It is noted that if the distance "Wc" between the base region 3 and collector's charge collection region 5 or the distance "d" between the collector's charge collection region 5 and substrate 1 is short, the avalanche breakdown occurs readily there. Accordingly, for example, Wc must not be less than t/2. The proper values of Wc and d can be estimated from the desirable withstand voltage. In Fig. 1, further, the p⁺ isolation walls 23, surface oxide film 24, emitter electrode 25, base electrode 26, collector electrode 27 and field electrode 28 are fabricated.

Adjustments of the specific resistance of epitaxial layer 2 to about 3 ohm-cm (n⁻ $\approx$ 1.5 x $10^{15}$ cm$^{-3}$), the distance t between the base region 3 and substrate 1 to approx. 7 $\mu$m, and the base diffusion depth to approx. 1.6 $\mu$m (surface concentration of approx. $10^{18}$ cm$^{-3}$ and base width of approx. 5 $\mu$m at surface) were found to give a base- collector withstand voltage BVcEo higher than 210 V . This is a substantial improvement when compared to a BVcBo around 60 V achieved by prior art. Horizontally aligned subregions of emitter region 4, base region 3, collector regions 2, 5, subregions which are primarily involved in determination of the withstand voltage characteristics, do not practically constitute any bipolar transistor ($\beta$ < 0.1), so BVcEo $\approx$ BVcBo. It is thus noted that an even larger difference is expected, when the comparison is made to the ordinary BVcEo value.

The JFET that uses the above collector's charge collection region 5 for drain is, so to say, a bulk FET cascaded to the above BTr. In this FET, the inner collector region 21 serves for source while the substrate 1 and base region 3 constitute the gate. In such FET, even when the drain voltage changes, the source is not affected much, supplying almost a constant current. After the depletion layers join to establish the pinch-off condition, therefore, the potential of the inner collector region 21 is not much affected by changes in the collector voltage Vc. The channel length of the above pseudo-FET can be assumed to be the distance between the aforementioned emitter-base and base-collector junctions (hereinafter abbreviated EB and BC junctions, respectively) in the horizontal direction. In the above example, the channel length was larger than 5 $\mu$m. The primary factor of causing the avalanche breakdown is the relation between the p base (gate) region 3 (or the p⁻ substrate 1) and n⁻ epitaxial layer 2. With the ordinary impurity concentration ratio p/n⁻ higher than 100, the withstand voltage is primarily determined both by the impurity concentration of epitaxial layer 2 and the length of horizontal region between the base region 3 and collector's charge collection region 5.

The compound transistor of Fig. 1 wherein the bulk JFET and BTr are fabricated in cascaded connection in such a manner that the pinch-off voltage Vp of the former is lower than the BVcEo is characterized by a high withstand voltage higher than 200 V. However, further studies made by the authors revealed such a weak point of the above compound transistor that the omission of the aforementioned embedded region of low resistivity increases the on resistance (saturation voltage).

The article of Werner et al. in IEEE Intern. Solid-State Circuits Conf. 24, Feb. 1981, p. 40-41, N.Y. describes a similar device to the device of Fig.1.

## OBJECTS AND SUMMARY OF THE INVENTION

Accordingly, it is an object of the invention to provide a semiconductor device that can achieve a high withstand voltage and yet assures a low on resistance and stable performances.

To achieve this object, the integrated circuit semiconductor structure is provided with the features of the characterizing part of claim 1.

Other objects, features and advantages of the invention will appear more fully from the following detailed description thereof taken in connection with the accompanying drawings.

## BRIEF DESCRIPTION OF THE DRAWINGS

Fig. 1 is a cross-section of a high withstand voltage switching component of prior art with the corresponding circuit diagram added.

Fig. 2 to 8 refer to examples of the present invention.

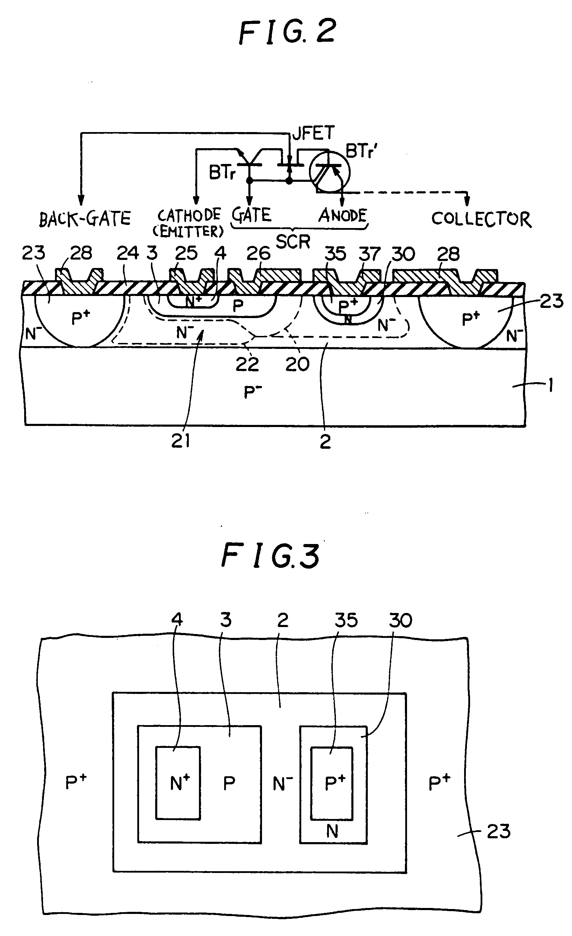

Namely, Fig. 2 is a cross-section of a high withstand voltage switching component of the invention with the corresponding circuit diagram added.

Fig. 3 is a plan view of Fig. 2 in which only the semiconductor regions are shown.

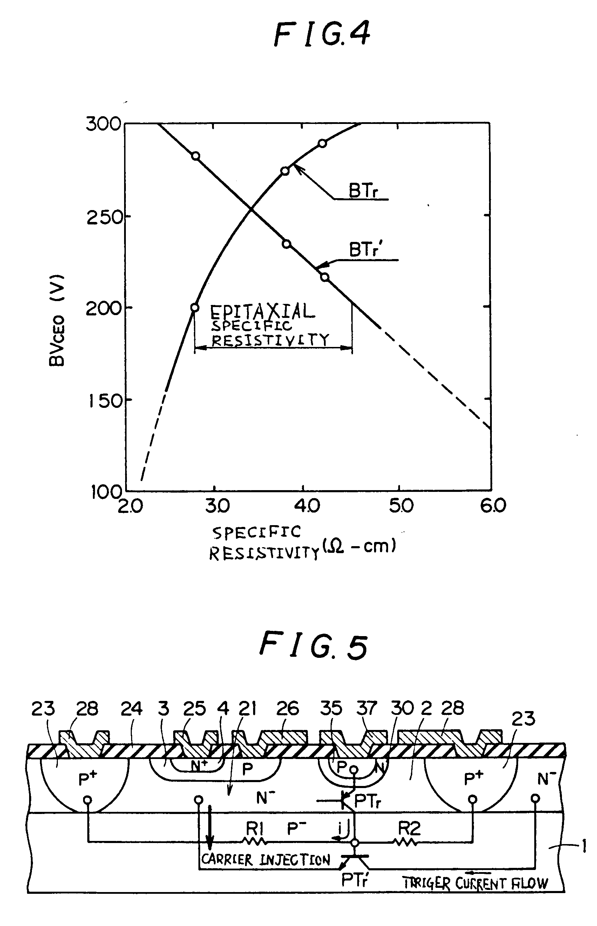

Fig. 4 is output characteristic curves of the high withstand voltage switching component of Fig. 2.

Fig. 5 is the same cross-section as Fig. 2 in which a circuit is drawn to explain the parasitic effect.

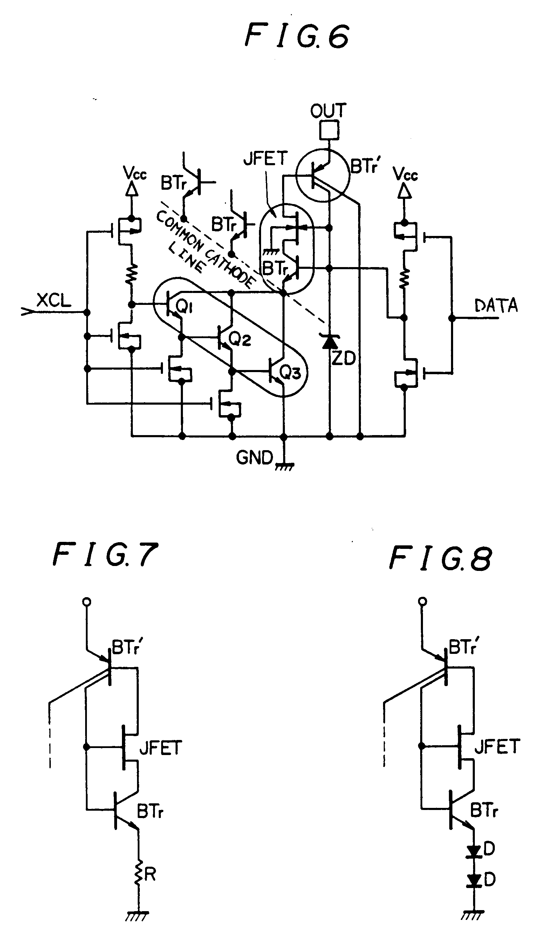

Fig. 6 is an equivalent circuit of a monolithic IC having built-in switching components what are free from the parasitic effect.

Figs. 7 and 8 are equivalent circuits, each illustrating an additional means to boost the collector potential.

## DESCRIPTION OF THE PREFERRED EMBODIMENTS

The invention will be more clearly understood with reference to the following examples.

Figs. 2 and 3 show a circuit part of a high withstand voltage monolithic IC embodying the invention. It is noted that in these figures regions common to the compound transistor shown in Fig. 1 are given the same numbers, of which explanation will be omitted.

Different from the prior art of Fig. 1, the semiconductor device of the invention has a diffused $p^+$ semiconductor region 35 in a n type well 30 formed in the $n^-$ epitaxial layer 2 instead of the $n^+$ diffused region 5 as mentioned above that provides the drain. In addition to the aforementioned two circuit components, namely, the npn bipolar transistor BTr composed of the $n+$ emitter region 4, p base region 3 and $n^-$ collector region 21 and the n-channel JFET composed of the p base region 3 and epitaxial layer 2 as gate and channel, respectively, the newly added $p^+$ region 35 forms a pnpn SCR (silicon controlled rectifier) together with the $n^-$ region 2 as the drain of the above JFET, p base region 3, and $n+$ emitter region 4 in a horizontal array. Namely, the $p^+$ region 35, $n+$ region 4, and p region 3 provide the anode, cathode and gate, respectively, of a thyristor structure in parallel connection. It is noted that in the drawings the pnp bipolar transistor composed of the regions 35, 2 and 3 is marked "BTr′".

With such formation of a SCR (thyristor) structure through the bulk JFET, while the npn transistor BTr can withstand a higher voltage because of the bulk JFET for the same reason as already mentioned (the pinch-off of the FET occurs before the start of any breakdown between collector and emitter), the pnp transistor BTr′ can also achieve a higher withstand voltage because the n well diffusion prevents the surface inversion. Another merit of the well diffusion is a high n type impurity concentration which limits the extension of the depletion layer 22 from the substrate 1 to suppress any punch-through between the substrate 1 and $p^+$ region 35. Though a $n^+$ embedded region (not shown), if formed, in the interface between the substrate 1 and epitaxial layer 2 just below the $p^+$ region 35 could have achieved the same effect, the n well 30 alone without such embedded region can still give a satisfactorily high withstand voltage. A design that omits formation of such embedded region could thus be used with an aim to reduce the steps of fabrication process.

In addition to the high withstand voltage characteristics as mentioned above, the semiconductor device of the invention is so designed that as the above SCR turns on, minority carriers are injected from the emitter region to the base region both in the pnp transistor BTr′ and npn transistor BTr. In the base region, the same number of carriers of opposite polarity appear to keep the region electrically neutral, exerting an effect to practically reduce the specific resistivity of that region (conductivity modulation). Since the base region of the pnp transistor is the channel region of bulk JFET, the channel resistance substantially declines in the above turn-on state. This is very preferable because of a lower on resistance. Further, in the turn-off state, the epitaxial layer 2 has a specific resistance high enough to positively cause the pinch-off at a voltage lower than the withstand voltage of npn transistor BTr, always assuring the high withstand voltage characteristic as mentioned above.

Fig. 4 is an example of actually plotted characteristic withstand voltage cures, which show dependency of the breakdown voltages (in ordinate) of individual transistors BTr and BTr′ on the condition of epitaxial layer, namely, the specific resistance thereof (in abscissa). From such curves, the preferable range of the specific resistance (namely, the impurity concentration, etc.) of epitaxial layer can be estimated.

It is noted that in the present example the base electrode 26 of BTr is disposed over between the anode and cathode of SCR covering a pn junction thereunder to stabilize the base potential while the field plate 28 is formed to cover another pn junction to suppress the breakdown in the surface of epitaxial layer.

Figs. 5 and 6 refer to another example of semiconductor device embodying the invention.

The authors examined the first example of semiconductor device for further improvements and because of an anxiety that since, generally, there was no practical example of a large current SCR fabricated in monolithic IC substrate, mere fabrication of such SCR structure might leave problems in practical applications. Particularly, referring to Fig. 5, a large current might partially flow into the substrate 1 as current i through a parasitic pnp transistor PTr composed of the p region 35, n region 2 and substrate 1 to boost the potential of substrate. If this occurs, another parasitic transistor PTr′ that comprises the n region whose potential is close to the substrate (namely, the collector region of the npn transistor of SCR) is forward biased to cause injection of minority carriers, presenting a possibility that the parasitic SCR confined within the isolation walls 23 and/or other SCR beyond such isolation walls may be accidentally turned on.

As mentioned above, actually, the SCR is often difficult to turn off. In this example, to avoid such difficulty, a circuit diagram of Fig. 6 is used to positively turn on and off the SCR.

Namely, to avoid the SCR from being accidentally turned on as mentioned above, it is necessary to have the potential of substrate 1 higher than the collector region (n type) of the npn transistor of SCR. To raise the potential of SCR's cathode (the aforementioned region 4) and thereby boost the potential of the above collector, a single Darlington circuit composed of transistor Q1, Q2 and Q3 is commonly connected to the cathodes of all SCRs. Further, to turn off the thyristor, the BTr must be turned off. For this end, a Zener diode ZD is used to clamp the base potential to the Zener voltage $V_{ZD}$. Then, as Q1, Q2 and Q3 are turned off at such clamped state, the transistor BTr comprising the thyristor switches off.

With the above transistors Q1, Q2 and Q3 in the Darlington connection on, the potential common to the collectors of these transistors is the cathode potential of SCR. This cathode potential Vk is the sum of the saturation potential of Q1, voltages between base and emitter of Q2 and Q3, namely,

$$Vk = V_{CE} = V_{CEsat(Q1)} + V_{BE(Q2)} + V_{BE(Q3)}.$$

For example, there may appear a bias of about 1.3 V. The substrate 1 can then never be forward biased to the n region 2 (or 22), so the carrier injection as mentioned above that may cause malfunction of other SCRs can be avoided.

These transistor Q1, Q2 and Q3 in Darlington connection also has a function to assure positive turning off of the SCR that is otherwise rather difficult to turn off. Namely, the transistors Q1 to Q3 switch on with the SCR (the transistors may be turned on earlier or later), while to turn off the SCR, not only the voltage applied to the gate of SCR vanishes but the transistors Q1 to Q3 switch off to stop the collector current of the npn transistor of SCR (cutoff of the on current) and thereby positively turn off the SCR.

The semiconductor device of the present example can actually achieve 500 mA at 4 V per unit gate 25 μm wide. A large output current density 50 times as high as the prior art can thus be attained with a substantial reduction in the on resistance. Further, the area per circuit component is also substantially reduced. For example, even an area 1/30 times as small as the conventional design provides satisfactory performances.

If turning off of the SCR as mentioned above is not particularly aimed at with the primary purpose being to suppress the parasitic effect as mentioned above, a resistor "R" or diode "D" may be connected as shown in Figs. 7 or 8, respectively, to boost the cathode potential. Such resistor or diode may have a rather lower withstand voltage.

For example, in the above examples, it is not always necessary to provide the n well 30. Even when such well 30 is omitted, however, other semiconductor regions may be fabricated almost in conformity to the example of Fig. 1 with respect to the configuration, size, impurity concentration, etc. Further, the above example may be reversed in conductivity types of individual semiconductor regions. It is noted that the semiconductor device of the invention will find various applications as a high withstand voltage switching device. For example, the device may be widely used as the display driver.

In the invention, as mentioned above, a bipolar transistor is fabricated in the semiconductor layer formed on a substrate in such a manner that the collector and base regions thereof constitute the channel and gate of a JFET structure while a semiconductor region of the first conductivity type formed in the above semiconductor layer, the above semiconductor layer itself, the base and emitter regions of the above bipolar transistor constitute a thyristor structure. The above bipolar transistor can thus be fabricated for a high withstand voltage characteristic since the above JFET is pinched off to prevent any breakdown between the collector and emitter regions.

Further, as the above thyristor structure is turned on, minority carriers are injected from the emitter region into the base region in individual transistors comprising this thyristor structure, when in the base region of one of these transistors (namely, the region corresponding to the channel of the above JFET) an equivalent number of majority carriers are generated to maintain the electrical neutrality. These majority carriers substantially reduce the specific resistance of base region (namely, the channel) to lower the on resistance of the thyristor.

## Claims

1. An integrated circuit semiconductor structure comprising:

   semiconductor substrate means including a semiconductor body portion (1) of a first conductivity type and a semiconductor layer portion (2) of a second conductivity type disposed on said semiconductor body portion, a PN junction defined between said semiconductor body portion of said first conductivity type and said semiconductor layer portion of said second conductivity type electrically isolating said semiconductor layer portion of said second conductivity type from said semiconductor body portion of said first conductivity type;

   a first dopant region (3) of said first conductivity type disposed in said semiconductor layer portion of said second conductivity type and opening onto the surface thereof;

   a second dopant region (4) of said second conductivity type disposed within said first dopant region of said first conductivity type and opening onto the surface of said first dopant region;

   said semiconductor layer portions (2), said first dopant region (3), and said second dopant region (4) defining collector (21), base, and emitter regions respectively for providing a vertical bipolar transistor;

   a third dopant region (30) of said second conductivity type disposed in said semiconductor layer portion (2) and having a higher dopant concentration in relation thereto, said third dopant region opening onto the surface of said semiconductor layer portion (2) and disposed in laterally spaced relationship with respect to said first dopant region (3); and

   a JFET having source and drain regions respectively provided by the collector region (21) of said vertical bipolar transistor and said third dopant region (30) and having a gate defined by said base region (3) of said vertical bipolar transistor; characterized in that

   a fourth dopant region (35) of said first conductivity type is provided, said fourth dopant region being disposed within said third dopant region (30) and opening onto the surface of said third dopant region;

   said fourth dopant region (35) cooperating with said semiconductor layer portion (2) and said first dopant region (3) in respectively defining the emitter, base and collector regions of a lateral bipolar transistor connected in a thyristor configuration to said vertical bipolar transistor through said JFET; and said JFET enabling said vertical bipolar transistor to withstand a higher voltage signal by achieving a pinch-off condition before the onset of voltage breakdown between the collector and emitter regions of said vertical bipolar transistor, and said lateral bipolar transistor having the capabilitiy of achieving a higher withstand voltage due to the prevention of surface inversion by said third dopant region (30).

2. An integrated circuit semiconductor structure as set forth in Claim 1, further characterized in that said fourth dopant region (35) of said lateral bipolar transistor forms the anode, said second dopant region (4) providing the emitter region of said vertical bipolar transistor forms the cathode, and said first dopant region (3) defining the base region of said vertical bipolar transistor and the collector region (21) of said lateral bipolar transistor forms the gate of said thyristor configuration.

3.  An integrated circuit semiconductor structure as set forth in either of Claims 1 or 2, further characterized in that said thyristor configuration is disposed in parallel with said JFET.

4.  An integrated circuit semiconductor structure as set forth in Claim 2, further characterized in that said thyristor configuration includes circuit means operably connected to said second dopant region (4) providing said emitter region of said vertical bipolar transistor and forming said cathode of said thyristor configuration to boost the potential of said cathode.

5.  An integrated circuit semiconductor structure as set forth in Claim 4, further characterized in that said circuit means comprises a plurality of transistors (Q1, Q2, Q3) in Darlington connection with the collector of each of said plurality of transistors being commonly connected to said cathode of said thyristor configuration.

6.  An integrated circuit semiconductor structure as set forth in Claim 1, further characterized in that a fifth dopant region (23) of said first conductivity type is provided, said fifth dopant region being disposed in said semiconductor layer portion (2) and extending into said semiconductor body portion (1), said fifth dopant region (23) opening onto the surface of said semiconductor layer portion (2) and bounding said vertical bipolar transistor, said lateral bipolar transistor and said JFET to define an electrically isolating wall;
a base electrode (26) disposed on said first dopant region (3) defining said base region of said vertical bipolar transistor and said collector region of said lateral bipolar transistor;
a field electrode (28) disposed on said fifth dopant region (23) defining said electrically isolating wall; and
said base electrode and said field electrode respectively being disposed so as to extend across respective PN junctions in overlying relationship thereto.

**Patentansprüche**

1.  Integrierte Halbleiterschaltungsstruktur, enthaltend:
ein Halbleitersubstratmittel mit einem Halbleiterkörperabschnitt (1) eines ersten Leitungstyps und einem Halbleiterschichtabschnitt (2) eines zweiten Leitungstyps auf dem Halbleiterkörperabschnitt, einem PN-Übergang zwischen dem Halbleiterkörperabschnitt des ersten Leitungstyps und dem Halbleiterschichtabschnitt des zweiten Leitungstyps, der den Halbleiterschichtabschnitt des zweiten Leitungstyps von dem Halbleiterkörperabschnitt des ersten Leitungstyps elektrisch isoliert;
eine erste Dotierungzone (3) des ersten Leitungstyps in dem Halbleiterschichtabschnitt des zweiten Leitungstyps mit Öffnung zu dessen Oberfläche;
eine zweite Dotierungszone (4) des zweiten Leitungstyps innerhalb der ersten Dotierungzone des ersten Leitungstyps mit Öffnung zu der Oberfläche der ersten Dotierungzone;
wobei der Halbleiterschichtabschnitt (2), die erste Dotierungzone (3) und die zweite Dotierungszone (4) Kollektor(21) Basis- bzw. Emitterzonen für die Bildung eines vertikalen bipolaren Transistors definieren;
eine dritte Dotierungszone (30) des zweiten Leitungstyps in dem Halbleiterschichtabschnitt (2) mit einer höheren Dotierungskonzentration in Bezug zu diesem, wobei die dritte Dotierungszone sich zur Oberfläche des Halbleiterschichtabschnitts (2) öffnet und seitlich im Abstand in Bezug zu der ersten Dotierungszone (3) angeordnet ist; und
einen JFET mit Source- und Drain-Zonen, die von der Kollektor-Zone (21) des vertikalen, bipolaren Transistors bzw. von der dritten Dotierungszone (30) gebildet sind und der eine von der Basiszone (3) des vertikalen bipolaren Transistors gebildete Gate-Zone aufweist;
dadurch gekennzeichnet, daß
eine vierte Dotierungszone (35) des ersten Leitungstyps vorgesehen ist, wobei die vierte Dotierungszone innerhalb der dritten Dotierungszone (30) angeordnet ist und sich zur Oberfläche der dritten Dotierungszone hin öffnet;
wobei die vierte Dotierungzone (35) mit dem Halbleiterschichtabschnitt (2) und der ersten Dotierungszone (3) zusammenarbeitet, um jeweils die Emitter-, Basis- und Kollektorzonen eines lateralen bipolaren Transistors zu bilden, der in einer Thyristor-Konfiguration mit dem vertikalen bipolaren Transistor über den JFET verbunden ist;

und

wobei der JFET den vertikalen bipolaren Transistor befähigt, einem höheren Spannungssignal zu widerstehen, indem ein Abschnürzustand vor dem Einsetzen des Spannungsdurchbruchs zwischen den Kollektor- und Emitterzonen des vertikalen bipolaren Transistors erzielt wird, und wobei der laterale bipolare Transistor die Fähigkeit hat, eine höhere Spannungsbeständigkeit wegen der Verhinderung der Oberflächeninversion durch die dritte Dotierungszone (30) zu erzielen.

2. Integrierte Halbleiterschaltungsstruktur nach Anspruch 1, ferner dadurch gekennzeichnet, daß die vierte Dotierungszone (35) des lateralen bipolaren Transistors die Anode bildet, die zweite Dotierungszone (4), die die Emitterzone des vertikalen bipolaren Transistors bildet, die Kathode bildet, und die erste Dotierungszone (3), die die Basiszone des vertikalen bipolaren Transistors und die Kollektorzone (21) des lateralen bipolaren Transistors bildet, die Gate-Zone der Thyristorkonfiguration bildet.

3. Integrierte Halbleiterschaltungsstruktur nach Anspruch 1 oder 2, ferner dadurch gekennzeichnet, daß die Thyristorkonfiguration parallel zu dem JFET angeordnet ist.

4. Integrierte Halbleiterschaltungsstruktur nach Anspruch 2, ferner dadurch gekennzeichnet, daß die Thyristorkonfiguration Schaltungsmittel enthält, die wirkungsmäßig mit der zweiten Dotierungszone (4) verbunden sind, die die Emitterzone des vertikalen bipolaren Transistors bildet und die die Kathode der Thyristorkonfiguration bildet, damit das Potential der Kathode angehoben wird.

5. Integrierte Halbleiterschaltungsstruktur nach Anspruch 4, ferner dadurch gekennzeichnet, daß die Schaltungsmittel mehrere Transistoren (Q1, Q2, Q3) in Darlington-Schaltung enthalten, wobei der Kollektor jedes der mehreren Transistoren gemeinsam mit der Kathode der Thyristorkonfiguration verbunden ist.

6. Integrierte Halbleiterschaltungsstruktur nach Anspruch 1, ferner dadurch gekennzeichnet, daß eine 5. Dotierungszone (23) des ersten Leitungstyps vorgesehen ist, wobei die 5. Dotierungszone in dem Halbleiterschichtabschnitt (2) angeordnet ist und sich in den Halbleiterkörperabschnitt (1) erstreckt, wobei sich die 5. Dotierungszone (23) zur Fläche des Halbleiterschichtabschnitts (2) hin öffnet und den vertikalen bipolaren Transistor, den lateralen bipolaren Transistor und JFET zur Bildung einer elektrischen isolierenden Wand umgrenzt;

daß eine auf der ersten Dotierungszone (3) angeordnete Basiselektrode (26) die Basiszone des vertikalen bipolaren Transistors und die Kollektorzone des lateralen bipolaren Transistors bildet.

daß eine auf der fünften Dotierungszone (23) gebildete Feldelektrode (28) die elektrisch isolierende Wand bildet; und

wobei die Basiselektrode und die Feldelektrode so angeordnet sind, daß sie sich in Überlagerungsbeziehung quer über jeweilige PN-Übergänge erstrecken.

**Revendications**

1. Structure semiconductrice à circuits intégrés, comprenant :

des moyens formant substrat semiconducteur comprenant une partie (1) formant corps semiconducteur possédant un premier type de conductivité et une partie (2) formant couche semiconductrice possédant un second type de conductivité et disposée sur ladite partie formant corps semiconducteur, une jonction PN définie entre ladite partie formant corps semiconducteur possédant ledit premier type de conductivité et ladite partie formant couche semiconductrice possédant ledit second type de conductivité, qui isole électriquement ladite partie formant couche semiconductrice possédant le second type de conductivité par rapport à ladite partie formant corps semiconducteur possédant ledit premier type de conductivité;

une première région de dopant (3) possédant ledit premier type de conductivité et disposée dans ladite partie formant couche semiconductrice possédant ledit second type de conductivité et débouchant à la surface de cette partie;

une seconde région de dopant (4) possédant ledit second type de conductivité et disposée dans ladite première région de dopant possédant ledit premier type de conductivité et débouchant à la surface de ladite première région de dopant;

ladite partie (2) formant couche semiconductrice, ladite première région de dopant (3) et ladite seconde

8

région de dopant (4) définissant respectivement la région de collecteur (21), la région de base et la région d'émetteur pour former un transistor bipolaire vertical;

une troisième région de dopant (30) possédant ledit second type de conductivité et disposée dans ladite partie (2) formant couche semiconductrice et possédant une concentration de substances dopantes, accrue par rapport à celle de cette partie, ladite troisième région de dopant débouchant dans la surface de ladite partie (2) formant couche semiconductrice et étant disposée en étant espacée latéralement par rapport à ladite première région de dopant (3); et

un transistor JFET possédant des régions de source et de drain formées respectivement par la région de collecteur (21) dudit transistor bipolaire vertical et par ladite troisième région de dopant (30) et possédant une grille définie par ladite région de base (3) dudit transistor bipolaire vertical;

caractérisée en ce

qu'il est prévu une quatrième région de dopant (35) possédant ledit premier type de conductivité, ladite quatrième région de dopant étant disposée à l'intérieur de ladite troisième région dopante (30) et débouchant dans la surface de ladite troisième région de dopant;

ladite quatrième région de dopant (35) coopérant avec ladite partie (2) formant couche semiconductrice et avec ladite première région de dopant (3) pour définir respectivement les régions d'émetteur, de base et de collecteur d'un transistor bipolaire latéral connecté selon une configuration de thyristor audit transistor bipolaire vertical, par l'intermédiaire dudit transistor JFET; et

ledit transistor JFET permettant audit transistor bipolaire vertical de résister à un signal de tension supérieure grâce à l'établissement d'une condition de pincement avant une apparition d'un claquage de tension entre les régions de collecteur et d'émetteur dudit transistor bipolaire vertical, et ledit transistor bipolaire latéral étant à même de produire une tension de maintien supérieure grâce au fait que ladite troisième région de dopant (30) empêche une inversion de surface.

2. Structure semiconductrice à circuits intégrés selon la revendication 1, caractérisée en outre en ce que ladite quatrième région de dopant (35) dudit transistor bipolaire latéral forme l'anode, ladite seconde région de dopante (4) constituant la région d'émetteur dudit transistor bipolaire vertical forme la cathode, et ladite première région de dopant (3), définissant la région de base dudit transistor bipolaire vertical et la région de collecteur (21) dudit transistor bipolaire latéral forme la grille de ladite configuration de thyristor.

3. Structure semiconductrice à circuits intégrés selon l'une des revendications 1 ou 2, caractérisée en outre en ce que ladite configuration de thyristors est disposée en parallèle avec ledit transistor JFET.

4. Structure semiconductrice à circuits intégrés selon la revendication 2, caractérisée en outre en ce que ladite configuration de thyristor comprend des moyens formant circuit raccordés de façon opérationnelle à ladite seconde région de dopant (4) constituant ladite région d'émetteur dudit transistor bipolaire vertical et formant ladite cathode de ladite configuration de thyristor afin d'accroître le potentiel de ladite cathode.

5. Structure semiconductrice à circuits intégrés selon la revendication 4, caractérisée en outre en ce que lesdits moyens formant circuit comprennent une pluralité de transistors (Q1, Q2, Q3) selon un montage de Darlington, dans lequel les collecteurs des différents transistors de l'ensemble de transistors sont raccordés en commun à ladite cathode de ladite configuration de thyristor.

6. Structure semiconductrice à circuits intégrés selon la revendication 1, caractérisée en outre en ce qu'il est prévu une cinquième région de dopant (23) possédant ledit premier type de conductivité, ladite cinquième région de dopant étant disposée dans ladite partie (2) formant couche semiconductrice et pénétrant dans ladite partie (1) formant corps semiconducteur, ladite cinquième région de dopant (23) débouchant dans la surface de ladite partie (2) formant couche semiconductrice et limitant ledit transistor bipolaire vertical, ledit transistor bipolaire latéral et ledit transistor JFET pour définir une paroi électriquement isolante;

une électrode de base (26) disposée sur ladite première région de dopant (3) définissant ladite région de base dudit transistor bipolaire vertical et ladite région de collecteur dudit transistor bipolaire latéral;

une électrode de champ (28) disposée sur la cinquième région de dopant (23) définissant ladite paroi électriquement isolante; et

ladite électrode de base et ladite électrode de champ étant disposées respectivement de manière à s'étendre en travers de jonction PN respectives, en chevauchement sur ces dernières.

# *FIG. 1* PRIOR ART

## FIG.2

## FIG.3

# F I G. 4

# F I G. 5

# FIG.6

# FIG.7

# FIG.8